# EUROPEAN PATENT APPLICATION

(11) **EP 1 739 743 A2**
(43) Date of publication of application: **03.01.2007**
(21) Application number: 05255821.0
(22) Date of filing: 20.09.2005
(51) Int. Cl.: H01L 23/373

(54) **Electronic component package including joint material for higher heat conductivity**

(30) Priority: 27.06.2005 JP 2005186004
(71) Applicant: FUJITSU LIMITED, Kawasaki-shi, Kanagawa 211-8588 (JP)
(72) Inventor: Nakamura, Naoaki, Kawasaki-shi Kanagawa 211-8588 (JP); Yoshimura, Hideaki, Kawasaki-shi Kanagawa 211-8588 (JP); Fukuzono, Kenji, Kawasaki-shi Kanagawa 211-8588 (JP); Sato, Toshihisa, Kawasaki-shi Kanagawa 211-8588 (JP)
(74) Representative: Hitching, Peter Matthew

(57) **Abstract**

An electronic component (21) is mounted on the surface of a printed wiring board (14). A heat conductive member (15) is received on the surface of the electronic component (21). A joint material (26) is interposed between the electronic component and the heat conductive member. The joint material is made of material containing Ag in a range exceeding 3wt% and In. The inventors have demonstrated that voids decrease at the boundary between the joint material and the electronic component as well as at the boundary between the joint material and the heat conductive member as the content of Ag increases in the overall weight of the joint material. The joint material is allowed to enjoy a higher heat conductivity as compared with a conventional solder material. The joint material allows the heat conductive member to efficiently receive heat from the electronic component.

## Description

### BACKGROUND OF THE INVENTION

### Field of the Invention:

The present invention relates to an electronic component package including a printedwiring board , an electronic component such as a LSI (Large-Scale Integrated circuit) chip mounted on the upper surface of the printed wiring board, and a heat conductive member received on the upper surface of the electronic component on the printed wiring board.

### Description of the Prior Art:

An electronic component package often includes a LSI chip mounted on a printed wiring board. A heat conductive member such as a heat sink is received on the upper surface of the LSI chip. For example, a joint material is interposed between the LSI chip and the heat sink, as disclosed in Japanese Patent Application Publication 2000-012748. The joint material is made of a solder material, for example. Sn-Pb is employed as the solder material, for example.

An activator such as flux is added to the solder material such as Sn-Pb so as to improve the wetness of the solder material. Such an addition of flux to the solder material, however, results in the generation of voids along the contact surfaces of the joint material with the heat sink and the LSI chip. The voids make the contact areas smaller between the joint material and the heat sink as well as between the joint material and the LSI chip. The smaller contact areas hinder an efficient heat transfer from the LSI chip to the heat sink through the joint material.

### SUMMARY OF THE INVENTION

It is accordingly an object of the present invention to provide an electronic component package reliably contributing to an effective heat transfer. In addition, it is an object of the present invention to provide a joined assembly greatly contributing to the realization of the electronic component package.

According to the present invention, there is provided an electronic component package comprising: a printed wiring board; an electronic component mounted on the surface of the printed wiring board; a heat conductive member received on the surface of the electronic component on the printed wiring board; and a joint material interposed between the electronic component and the heat conductive member, said joint material made of material containing Ag in a range exceeding 3wt% and In.

The electronic component package allows employment of the joint material made of material containing Ag in a range exceeding 3wt% and In. The inventors have demonstrated that voids decrease at the boundary between the joint material and the electronic component as well as at the boundary between the joint material and the heat conductive member as the content of Ag increases in the overall weight of the joint material. Moreover, the material containing Ag in a range exceeding 3wt% and In exhibits a lower heat resistance as compared with a conventional solder material such as Sn-Pb. The joint material is allowed to enjoy a higher heat conductivity as compared with a conventional solder material. Accordingly, the joint material of the present invention allows the heat conductive member to efficiently receive heat from the electronic component.

In particular, In is allowed to enjoy the elastic modulus lower than that of Pb. Even if stress is induced at the boundary between the heat conductive member and the joint material as well as at the boundary between the joint material and the electronic component based on the difference in the coefficient of thermal expansion between the heat conductive member and the electronic component, the joint material is allowed to reliably absorb the stress in a sufficient manner. Detachment can reliably be avoided between the heat conductive member and the joint material as well as between the joint material and the electronic component.

The joint material may have the melting point lower than the melting point of a terminal connecting the electronic component to the printed wiring board. The electronic component is mounted on the printed wiring board based on the terminal in the assembly of the electronic component package. The terminal melts in response to the applied heat. After the electronic component has been mounted on the printed wiring board, the heat conductive member is mounted on the electronic component based on the joint material. The joint material melts in response to the applied heat. As long as the melting point of the joint material is set lower than that of the terminal, the terminal is reliably prevented from suffering from a so-called secondary melting.

The joint material may have the melting point lower than the heatproof temperature of the electronic component in the electronic component package. As described above, the joint material melts in response to the applied heat when the heat conductive member is mounted on the electronic component. As long as the melting point of the joint material is lower than the heatproof temperature of the electronic component, the destruction of the electronic component can be avoided even when heat is applied to melt the joint material. The melting point of the joint material may also be set lower than the heatproof temperature of the printed wiring board, for example. The destruction of the printed wiring board can in this manner be avoided even when heat is applied to melt the joint material.

The material contains Ag in a range exceeding 3wt% and In allows establishment of a higher liquidus and solidus temperatures as the content of Ag increases in the overall weight of the joint material. The content of Ag in the joint material may be controlled in accordance with the melting point of the terminal connecting the electronic component to the printed wiring board, the heatproof temperature of the electronic component, the heatproof temperature of the printedwiring board, and the like. The content of Ag may be set in a range equal to or below 20wt% in the overall weight of the joint material, for example.

A joined assembly may be provided to realize the electronic component package. The joined assembly may comprise: a first member at least partially exposing a first metal on the surface of the first member; a second member at least partially exposing a second metal on the surface of the second member, said second member received on the first metal at the second metal; and a joint material interposed between the first and second metals, said joint material made of material containing Ag in a range exceeding 3wt% and In.

### BRIEF DESCRIPTION OF THE DRAWINGS

The above and other objects, features and advantages of the present invention will become apparent from the following description of the preferred embodiment in conjunction with the accompanying drawings, wherein:
Fig. 1 is a perspective view schematically illustrating the structure of a motherboard;
Fig. 2 is a sectional view taken along the line 2-2 in Fig. 1 for schematically illustrating the structure of an electronic component package;
Fig. 3 is a table showing the liquidus and solidus in relation to the content of Ag;
Fig. 4 is a radiograph showing the contact surfaces between a joint material and a heat sink according to a comparative example;
Fig. 5 is a radiograph showing the contact surfaces between a joint material and a heat sink according to a first specific example;
Fig. 6 is a radiograph showing the contact surfaces between a joint material and a heat sink according to a second specific example;
Fig. 7 is a radiograph showing the contact surfaces between a joint material and a heat sink according to a third specific example;
Fig. 8 is a radiograph showing the contact surfaces between a joint material and a heat sink according to a fourth specific example; and
Fig. 9 is a graph showing the correlation between the thickness of the joint material and the heat resistance of the joint material;

### DESCRIPTION OF THE PREFERRED EMBODIMENT

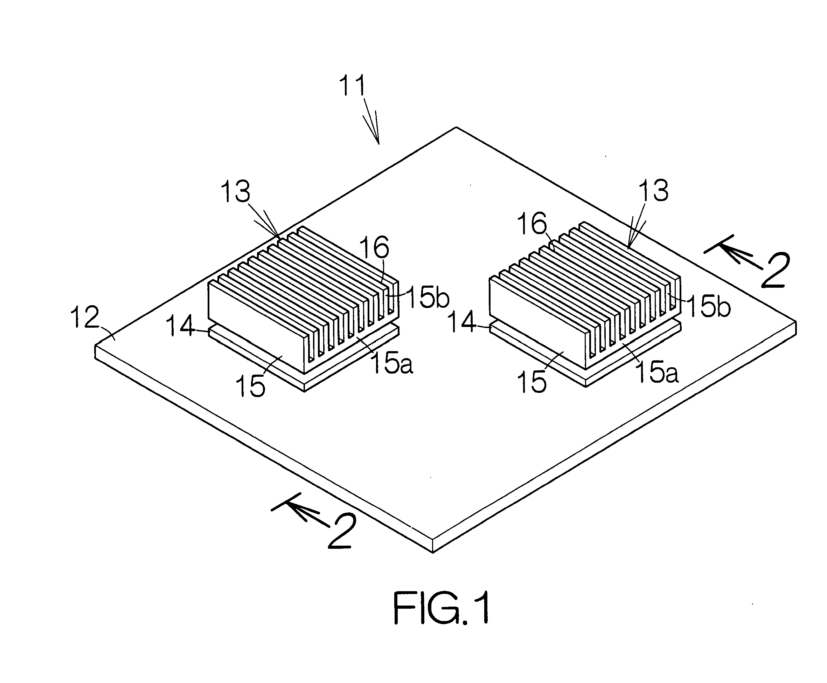

Fig. 1 schematically illustrates the structure of a motherboard 11. The motherboard 11 includes a large-sized printed wiring board 12. An electronic component package or packages 13 is mounted on the front surface of the printed wiring board 12. The individual electronic component packages 13 include a small-seized printed wiring board 14 mounted on the front surface of the printed wiring board 12. A resinous or ceramic substrate may be utilized for the printed wiring board 14, for example.

A heat conductive member or heat sink 15 is received on the printed wiring board 14. The heat sink 15 includes a plate-shaped main body or heat receiver 15a and fins 15b standing upright in a vertical direction from the heat receiver 15a. The fins 15b extend in parallel with one another. Air passages 16 are thus defined between the individual adjacent pairs of the fins 15b. The electronic component package 13 of this type enables an efficient heat radiation from the fins 15b when air flows through the air passages 16 with the assistance of a blower unit, not shown, for example. The heat sink 15 may be made of Cu, Al, a composite material mainly composed of Cu and/or Al, a higher heat conductive material such as a carbon composite material, or the like. Casting may be employed to form the heat sink 15.

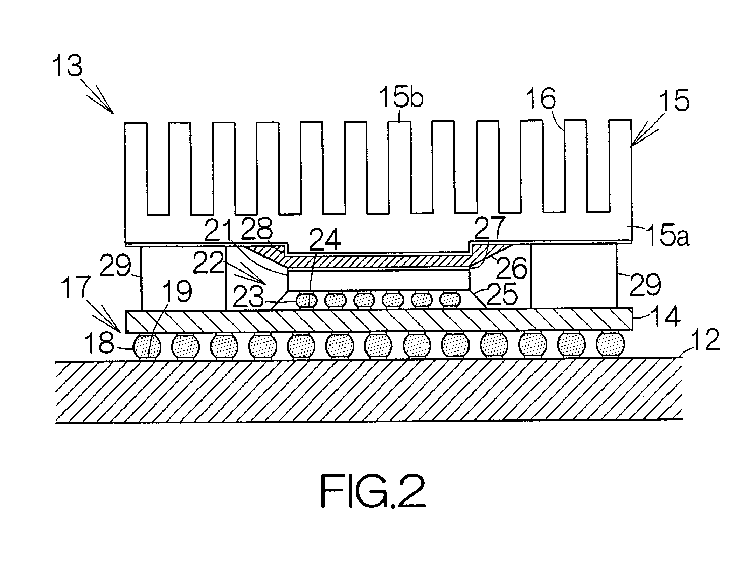

As shown in Fig. 2, a ball grid array 17 is formed on the back surface of the printed wiring board 14. The ball grid array 17 is utilized to mount the printed wiring board 14 on the front surface of the printed wiring board 12. The ball grid array 17 includes spherical electrically-conductive terminals 18 arranged in accordance with a given pattern. The individual electrically-conductive terminals 18 are received on corresponding terminal pads or electrically-conductive pads 19 on the printed wiring board 12. Electric connection is in this manner established between the printed wiring board 14 and the printed wiring board 12. Here, the electrically-conductive terminals 18 may be made of Sn-37Pb(wt%), for example.

An electronic component or LSI chip 21 is mounted on the printed wiring board 14. A ball grid array 22 is formed on the back surface of the LSI chip 21. The ball grid array 22 is utilized to mount the LSI chip 21 on the printed wiring board 14. The ball grid array 22 includes spherical electrically-conductive terminals 23 arranged in accordance with a given pattern in the same manner as the ball grid array 17. The individual electrically-conductive terminals 23 are received on corresponding terminal pads or electrically-conductive pads 24 on the printed wiring board 14. Electric connection is in this manner established between the LSI chip 21 and the printed wiring board 14. Here, the electrically-conductive terminals 23 may be made of Sn-37Pb(wt%), for example.

Electronic elements such as capacitors and chip resistors, both not shown, may be mounted on the printed wiring board 14 in addition to the LSI chip 21, for example. The electronic elements may be mounted on the back surface of the printed wiring board 14, for example. An underfill material film 25 is interposed between the LSI chip 21 and the printed wiring board 14. The underfill material film 25 fills the space around the electrically-conductive terminals 23. The electrically-conductive terminals 23 can reliably be insulated from each other in this manner. The underfill material film 25 may be made of a resin material mainly composed of epoxy resin, for example.

The aforementioned heat sink 15 is received on the front surface of the LSI chip 21. A joint material 26 is interposed between the heat sink 15 and the LSI chip 21. The joint material 26 may be made of material containing Ag in a range exceeding 3wt% and In. Here, the joint material 26 is made of an In-Ag alloy. The content of Ag may be set in a range equal to or below 20wt% in the overall weight of the joint material 26 , for example.

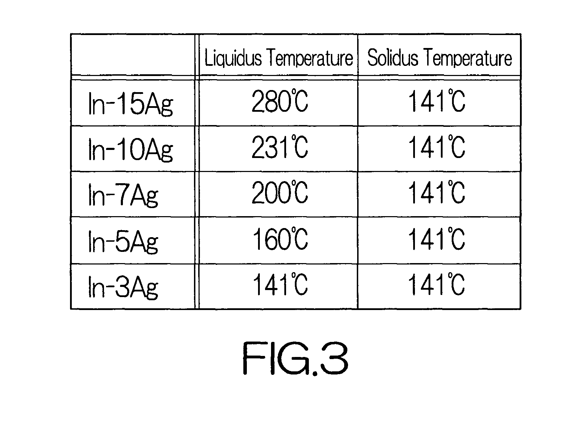

As shown in Fig. 3, the In-3Ag(wt%) alloy has the liquidus and solidus temperatures of 141 degrees Celsius. This temperature corresponds to the eutectic temperature. An increase in the content of Ag in the material leads to a higher liquidus temperature above 141 degrees Celsius. On the other hand, even though the content of Ag in the material increases, the solidus temperature stays at 141 degrees Celsius. Accordingly, as the content of Ag in the material increases, the difference enlarges between the liquidus and solidus temperatures.

Referring again to Fig. 2, a first metal or first metallic film 27 is formed on the front surface of the LSI chip 21. The LSI chip 21 as a first member of the present invention at least partially exposes the first metallic film 27 on the front surface. Here, the first metallic film 27 may be formed on the entire front surface of the LSI chip 21. The first metallic film 27 may be made of a layered film of a Ti film and an Au film, a layered film of a Ti film and a Cu film, or the like, for example. The LSI chip 21 in this manner receives the joint material 26 at the first metallic film 27.

The bottom surface of the heat sink 15 is opposed to the LSI chip 21. A second metal or second metallic film 28 is formed on the bottom surface or opposed surface of the heat sink 15. The heat sink 15 as a second member of the present invention at least partially exposes the second metallic film 28 on the opposed surface. The second metallic film 28 may be made of a layered film of a Ni film and a Au film, for example. The joint material 26 in this manner receives the second metallic film 28 on the heat sink 15.

The joint material 26 is in this manner interposed between the first and second metallic films 27, 28. In other words, the heat sink 15 allows the second metallic film 28 to get contacted with the first metallic film 27 on the LSI chip 21. The joint material 26 thus serves to couple the heat sink 15 with the LSI chip 21. Here, the LSI chip 21 as a first member, the heat sink 15 as a second member and the joint material 26 in combination form the joined assembly according to the present invention.

Support members 29 are utilized to fix the heat sink 15 to the printed wiring board 14. The support members 29 may be made of a material having an expansivity approximate to that of the printed circuit board 14, for example. Such a material may be Cu, a stainless steel, or the like. Adhesive sheets, not shown, are interposed between the heat sink 15 and the support members 29 as well as between the support members 29 and the printed wiring board 14 so as to fix the heat sink 15 to the printed wiring board 14, for example. An epoxy adhesive sheet may be employed as the adhesive sheet, for example. Fiberglass or inorganic filler may be included in the adhesive sheet, for example. The fiberglass or inorganic filler serves to keep the thickness of the adhesive sheet uniform.

The motherboard 11 of this type suffers from heat generated at the LSI chip 21 in operation. The heat of the LSI chip 21 is transmitted to the heat receiver 15a of the heat sink 15 through the first metallic film 27, the joint material 26 and the second metallic film 28. The heat then conducts to the fins 15b from the heat receiver 15a. The fins 15b serves to establish the surface of a larger area for radiation of the heat. The blower unit operates to generate airflow through the air passages 16, for example. The LSI chip 21 is in this manner effectively prevented from rise in temperature.

Next, a brief description will be made on a method of making the electronic component package 13. First of all, the printed wiring board 14 is prepared. A ceramic or organic substrate may be applied to the printed wiring board 14. The ceramic or organic substrate may have a thickness in a range from 0.4mm to 0.7mm, for example. Material such as Al₂O₃, AlN, or glass may be included in the ceramic substrate, for example. The support members 29 are fixed to the front surface of the printed wiring board 14. The adhesive sheets are interposed between the printed wiring board 14 and the support members 29 so as to fix the support members 29 to the printed wiring board 14. The support members 29 are pressed against the front surface of the printed wiring board 14. The pressing force may be set equal to or below 1.96x10⁻³[Pa], for example.

The LSI chip 21 is mounted on the front surface of the printed wiring board 14. Solder material such as Sn-37Pb may be employed as the electrically-conductive terminals 23, for example. The electrically-conductive terminals 23 are in advance attached on the bottom surface of the LSI chip 21. The individual electrically-conductive terminals 23 are placed on the electrically-conductive pads 24. Heat is then applied to the electrically-conductive terminals 23. The peak of the temperature is set equal to or below 230 degrees Celsius, for example. The electrically-conductive terminals 23 thus melt. The electrically-conductive terminals 23 gets cured or hardened when cooled thereafter. The LSI chip 21 is in this manner mounted on the printed wiring board 14.

The underfill material film 25 is then interposed between the LSI chip 21 and the printed wiring board 14. A thermosetting resin material in liquid state may be prepared to fill the space between the LSI chip 21 and the printed circuit board 14 for establishment of the underfill material film 25. The resin material may mainly contain epoxy. When heat of 150 degrees Celsius is applied to the resin material, for example, the resin material gets cured. The underfill material film 25 is in this manner formed between the LSI chip 21 and the printed wiring board 14 based on the cured resin material.

The second metallic film 28 is overlaid on the opposed surface of the heat sink 15 over a predetermined range. A Ni film having the thickness of 3µm approximately is formed on the opposed surface of the heat sink 15, for example. A Au film having the thickness of 0.3µm approximately is then formed on the surface of the Ni film. Electroplating is employed to form the Ni and Au films , for example. The Ni and Au films thus provide the aforementioned second metallic film 28.

The first metallic film 27 is overlaid on the front surface of the LSI chip 21. A Ti film having the thickness of 500nm approximately is formed on the front surface of the LSI chip 21, for example. A Au film having the thickness of 0.3µm approximately is then formed on the surface of the Ti film, for example. Sputtering is employed to form the Ti and Au films, for example. The Ti and Au films on the front surface of the LSI chip 21 thus provide the aforementioned second metallic film 28.

Here, the heat sink 15 may be made of oxygen-free copper, for example. The second metallic film 28 made of the Ni and Au films serves to avoid oxidation of the opposed surface of the heat sink 15. The first and second metallic films 27, 28 serve to improve the wetness of the joint material 26.

The heat sink 15 is then mounted on the front surface of the LSI chip 21. The joint material 26 is interposed between the first and second metallic films 27, 28 so as to mount the heat sink 15 on the LSI chip 21. The joint material 26 is formed in the shape of a sheet, for example. Here, the joint material 26 may be made of In-10Ag, for example. Adhesive sheets are simultaneously interposed between the heat sink 15 and the support members 29. The support members 29 are pressed against the front surface of the printed wiring board 14. The pressing force may be set equal to or below 1.96x10⁻³[Pa], for example. Heat is then applied to the heat sink 15 and the LSI chip 21. The joint material 26 thus melts. The joint material gets cured or hardened when cooled thereafter. The heat sink 15 is in this manner mounted on the front surface of the LSI chip 21.

The electrically-conductive terminals 18 are thereafter attached to the back surface of the printed wiring board 14. The electrically-conductive terminals 18 are made of a solder material such as Sn-37Pb, for example. Heat is applied to the electrically-conductive terminals 18. The peak of the temperature is set at 230 degrees Celsius approximately, for example. The electrically-conductive terminals 18 thus melt. The electrically-conductive terminals 18 gets cured or hardened when cooled thereafter. The electrically-conductive terminals 18 are in this manner attached to the back surface of the printed wiring board 14. The production of the electronic component package 13 has been completed. The electronic component package 13 may then be mounted on the front surface of the printed wiring board 12.

The electronic component package 13 of this type utilizes the joint material 26 made of In-10Ag in the aforementioned manner. The joint material 26 is thus allowed to have the liquidus temperature of 231 degrees Celsius as is apparent from Fig. 3. The electrically-conductive terminals 18, 23 made of Sn-Pb37 usually melt at a temperature in a range equal to or lower than 230 degrees Celsius, for example. Accordingly, the joint material 26 is reliably prevented from the secondary melting even when heat is applied to melt the electrically-conductive terminals 18, 23. As long as the liquidus temperature or melting point of the joint material 26 is set higher than the melting point of the electrically-conductive terminals 18, 23, the establishment of a Ni film can be eliminated in the first metallic film 27. The structure of the first metallic film 27 can be simplified than ever.

On the other hand, if In-5Ag or In-7Ag is utilized for the joint material 26, the joint material 26 is allowed to have the liquidus temperature of 160 or 200 degrees Celsius, as is apparent from Fig. 3. In other words, the melting point of the joint material 26 is set lower than that of the electrically-conductive terminals 18, 23. Even if an organic substrate is utilized for the printed wiring board 14, the joint material 26 is allowed to melt at a temperature within the range of the heatproof temperature of the printed wiring board 14. The joint material 26 can also be melted at the temperature within the range of the heatproof temperature of the electronic component, namely of the LSI chip 21. As long as the melting point of the joint material 26 is in this manner set lower than that of the electrically-conductive terminals 18, 23 and the heatproof temperatures of the printed wiring board 14 and the LSI chip 21, the secondarymelting of the electrically-conductive terminals 18, 23 and the destruction of the printed wiring board 14 and the LSI chip 21 can be avoided.

In particular, In has the elastic modulus lower than that of Pb, for example. In has the elastic modulus in a range from one fourth to a half of that of Pb. Even if stress is induced at the boundary between the heat sink 15 and the joint material 26 as well as at the boundary between the joint material 26 and the LSI chip 21 based on the difference in the coefficient of thermal expansion between the heat sink 15 and the LSI chip 21, the joint material 26 is allowed to reliably absorb the stress in a sufficient manner. Detachment can reliably be avoided between the heat sink 15 and the joint material 26 as well as between the joint material 26 and the LSI chip 21.

Next, the inventors have observed generation of voids with respect to the composition of the joint material 26. The inventors prepared first to fourth examples of the invention as well as a comparative example in the observation. In-5Ag was employed to form the joint material 26 in the first example. In-7Ag was employed to form the joint material 26 in the second example. In-10Ag was employed to form the joint material 26 in the third example. In-15Ag was employed to form the joint material 26 in the fourth example. In-3Ag was employed to form a joint material in the comparative example. The joint material in the first to fourth examples and the comparative example was interposed between the heat sink 15 and the LSI chip 21. The contact surfaces were visually observed between the joint material 26 and the heat sink 15, for example.

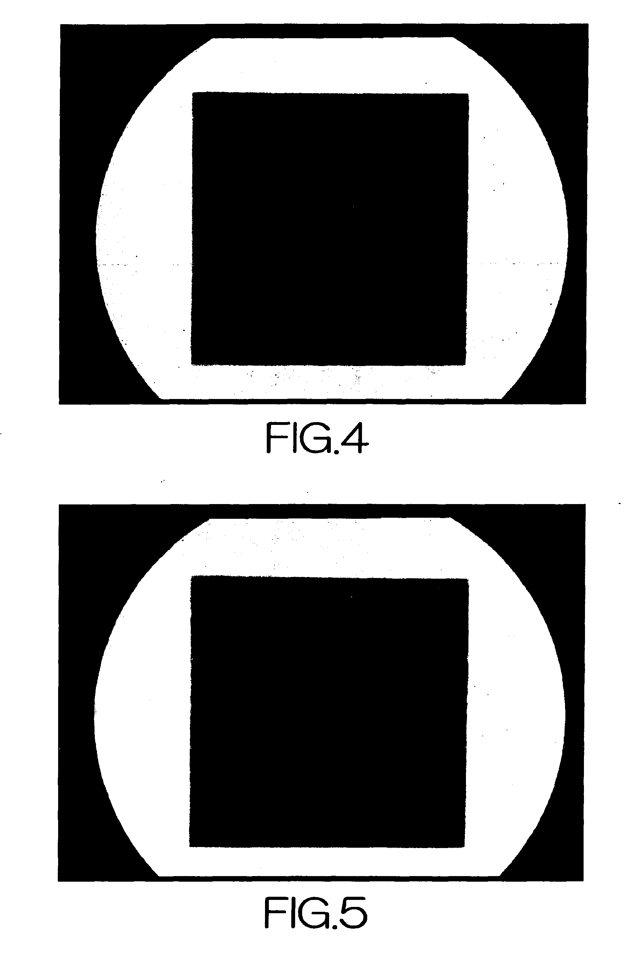

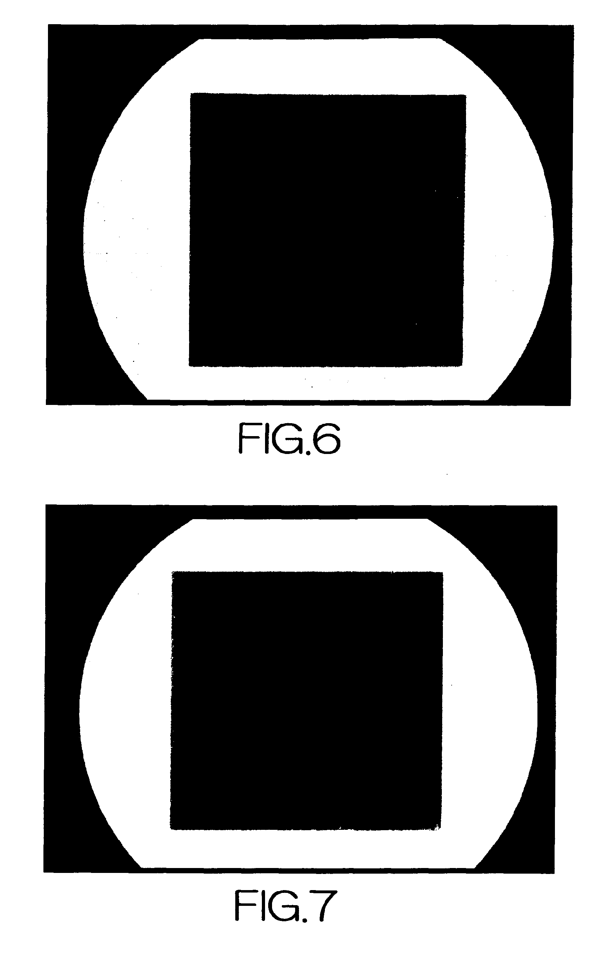

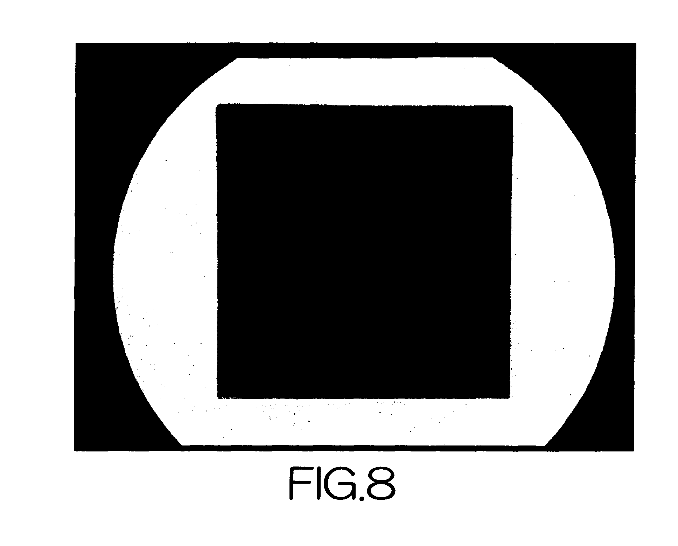

As shown in Fig. 4, a large number of voids were generated in the contact surface of the joint material in the comparative example. As shown in Fig. 5, a smaller number of voids were generated in the contact surface in the first example as compared with the comparative example. Voids still get reduced in number in the second example, as shown in Fig. 6, rather than the first example. Voids still gets reduced in number in the third example, as shown in Fig. 7. Voids were hardly observed on the contact surface in the fourth example, as shown in Fig. 8.

Aforementioned observation reveals that voids get reduced in number as the content of Ag increases in the overall weight of the joint material 26. In other words, the wetness of the joint material 26 improves as the content of Ag increases in the joint material 26. As is apparent from Fig. 3, it was confirmed that voids decrease as the difference gets larger between the solidus and liquidus temperatures. Voids of a reduced number enables a reliably contact between the heat sink 15 and the joint material 26 as well as between the LSI chip 21 and the joint material 26 without addition of activator such as flux. The heat sink 15 is thus allowed to efficiently receive heat from the LSI chip 21.

Next, the inventors have measured the thermal resistance of the joint material 26. The inventors prepared a specific example of the invention and first to third comparative examples for the measurement. In-10Ag was employed in the specific example. In-48Sn was employed in the first comparative example. Sn-20Pb was employed in the second comparative example. The multilayered film of Sn-20Pb, Sn-95Pb and Sn-20Pb was employed in the third comparative example. The specific example and the first to third comparative examples were subjected to measurement of heat resistance [°C/W].

The specific example exhibited the heat resistance equal to 0.0383[°C/W]. The heat resistance of 0.0696[°C/W] was obtained for the first comparative example. The heat resistance of 0.0543[°C/W] was obtained for the second comparative example. The third comparative example exhibited the heat resistance of 0.0545[°C/W]. The specific example was allowed to enjoy a smaller heat resistance rather than the first to third comparative examples. The joint material 26 of the specific example is allowed to enjoy a superior heat conductivity rather than a joint material made of a conventional solder material. The measurement has reveals that the joint material 26 of the type reliably enables an efficient transmission of heat from the LSI chip 21 to the heat sink 15.

Next, the inventors have observed the correlation between the thickness and the heat resistance of the joint material 26. The inventors prepared a specific example and first to third comparative examples for the observation. In-10Ag was employed in the specific example. The multilayered film of Sn-37Pb, Sn-95Pb and Sn-37Pb was employed in the first comparative example. Sn-20Pb was employed in the second comparative material. In-52Sn was employed in the third comparative example. The inventors prepared three samples, respectively having the thickness of 100µm, 200µm and 250µm, for each of the specific and first to third comparative examples. Each of the samples for the examples was subjected to the measurement of the heat resistance [°C/W].

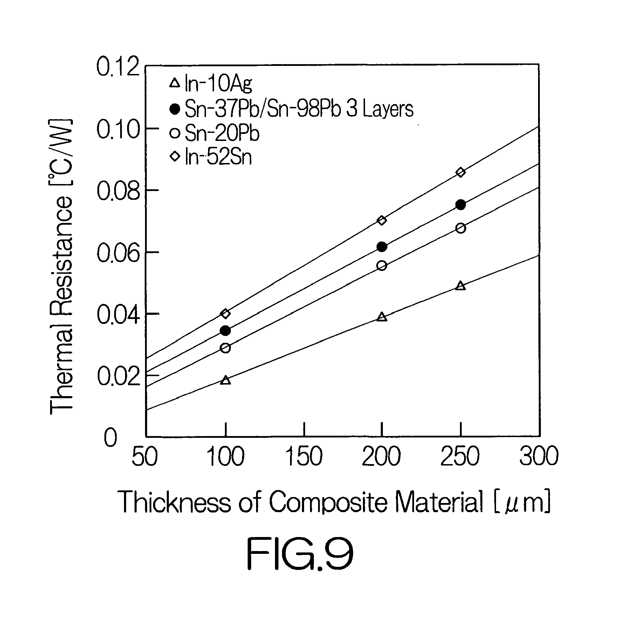

As shown in Fig. 9, the specific example was allowed to enjoy a smaller heat resistance rather than the first to third comparative examples for any samples. It was proved that the joint material 26 of the specific example is allowed to enjoy a superior heat conductivity rather than a joint material made of a conventional solder material. The heat sink 15 is thus allowed to efficiently receive heat from the LSI chip 21.

## Claims

1. An electronic component package comprising:
a printed wiring board;
an electronic component mounted on a surface of the printed wiring board;
a heat conductive member received on a surface of the electronic component on the printed wiring board; and
a joint material interposed between the electronic component and the heat conductive member, said joint material made of material containing Ag in a range exceeding 3wt% and In.

2. The electronic component package according to claim 1, wherein the joint material has a melting point lower than a melting point of a terminal connecting the electronic component to the printed wiring board.

3. The electronic component package according to claim 1, wherein the joint material has a melting point lower than heatproof temperature of the electronic component.

4. A joined assembly comprising:
a first member at least partially exposing a first metal on a surface of the first member;
a second member at least partially exposing a second metal on a surface of the second member, said second member received on the first metal at the second metal; and
a joint material interposed between the first and second metals, said joint material made of material containing Ag in a range exceeding 3wt% and In.
